# EUROPEAN PATENT APPLICATION

(11) **EP 2 600 393 A1**
(43) Date of publication of application: **05.06.2013**
(21) Application number: 11812267.0
(22) Date of filing: 13.07.2011
(51) Int. Cl.: H01L 21/338, H01L 21/28, H01L 29/41, H01L 29/423, H01L 29/49, H01L 29/778, H01L 29/812

(54) **SEMICONDUCTOR ELEMENT, HEMT ELEMENT, AND PRODUCTION METHOD FOR SEMICONDUCTOR ELEMENT**

(30) Priority: 29.07.2010 JP 2010170304
(71) Applicant: NGK Insulators, Ltd., Nagoya-shi, Aichi 467-8530 (JP)
(72) Inventor: MIYOSHI Makoto, Inazawa-shi Aichi 492-8137 (JP); SUMIYA Shigeaki, Nagoya-shi Aichi 467-8530 (JP); ICHIMURA Mikiya, Nagoya-shi Aichi 467-8530 (JP); SUGIYAMA Tomohiko, Nagoya-shi Aichi 467-8530 (JP); TANAKA Mitsuhiro, Nagoya-shi Aichi 467-8530 (JP)
(74) Representative: TBK
(86) International application number: PCT/JP2011/065938
(87) International publication number: WO 2012/014675

(57) **Abstract**

A semiconductor device is provided such that a reverse leak current is suppressed, and a Schottky junction between a gate electrode and an epitaxial substrate is sufficiently reinforced. The semiconductor device includes an epitaxial substrate formed by laminating a group of group-III nitride layers on a base substrate in such a manner that (0001) surfaces of said group-III nitride layers are substantially parallel to a substrate surface, and a Schottky electrode, in which the epitaxial substrate includes a channel layer formed of a first group-III nitride having a composition of Inₓ₁Al_{y1}Ga_{z1}N (x1 + y1 + z1 = 1, z1 > 0), a barrier layer formed of a second group-III nitride having a composition of Inₓ₂Al_{y2}N (x2 + y2 = 1, x2 > 0, y2 > 0), and a contact layer formed of a third group-III nitride having insularity and adjacent to the barrier layer, and the Schottky electrode is connected to the contact layer. In addition, a heat treatment is performed under a nitrogen atmosphere after the gate electrode has been formed.

## Description

### TECHNICAL FIELD

The present invention relates to a semiconductor device and more particularly to a semiconductor device having a Schottky diode junction between a multilayer-structured epitaxial substrate including a group-III nitride semiconductor, and a metal electrode.

### BACKGROUND ART

Nitride semiconductors having high breakdown electric field and high saturation electron velocity have been attracting attention as the next generation of semiconductor materials for high-frequency/high-power devices. For example, a HEMT (high-electron-mobility transistor) device formed by laminating a barrier layer composed of AlGaN and a channel layer composed of GaN takes advantage of the feature that high-concentration two-dimensional electron gas (2DEG) is generated at a lamination interface (hetero interface) owing to a polarization effect (spontaneous polarization effect and piezo polarization effect) inherent in a nitride material (hetero interface) (refer to non-document 1, for example).

As a base substrate of the substrate for HEMT device, for example, a single crystal (heterogeneous single crystal) having a composition different from that of a group-IIIgroup-III nitride, such as silicon and SiC, is used in some cases. In this case, a buffer layer such as a strained superlattice layer and a low-temperature growth buffer layer is typically formed as an initial growth layer on the base substrate. Therefore, the most basic configuration of a substrate for HEMT device using a base substrate formed of heterogeneous single crystal is obtained by epitaxially forming a barrier layer, a channel layer and a buffer layer on a base substrate. In addition, for the purpose of accelerating spatial confinement of two-dimensional electron gas, a spacer layer having a thickness of approximately 1 nm is provided between the barrier layer and the channel layer in some cases. The spacer layer is composed of, for example, AlN. Moreover, for the purposes of controlling an energy level on the topmost surface of the substrate for HEMT device and improving contact characteristics with an electrode, for example, a cap layer composed of an n-type GaN layer or a superlattice layer is formed on the barrier layer in some cases.

In a case of a nitride HEMT device having the most typical configuration in which a channel layer is formed of GaN and a barrier layer is formed of AlGaN, it is known that the concentration of two-dimensional electron gas existing in a substrate for HEMT device increases along with an increase in AlN mole fraction of AlGaN that forms the barrier layer (refer to non-patent document 2, for example). It is conceivable that controllable current density of a HEMT device, that is, power density capable of being utilized can be improved significantly if the concentration of two-dimensional electron gas can be increased significantly.

Further, growing attention is also paid to the HEMT device that has a low dependence on the piezo polarization effect, is capable of generating two-dimensional electron gas at high concentration almost only by spontaneous polarization, and has the structure with small strains, such as the HEMT device in which a channel layer is formed of GaN and a barrier layer is formed of InAlN (refer to non-patent document 3, for example).

In the case where the HEMT device is manufactured by forming the channel layer with GaN, and the barrier layer with InAlN, a junction between the gate electrode and the barrier layer is a Schottky junction in general. However, in this case, a large leak current could be generated when a reverse voltage is applied to the Schottky junction, depending on the composition and a formation condition of the InAlN layer.

In addition, in a process for manufacturing a semiconductor device having the Schottky diode junction using a group-III nitride semiconductor, a Schottky electrode including a metal material having a high work function, such as Pd, Pt, or Ni is formed on a semiconductor layer by vapor deposition, but a heat treatment is not performed after the vapor deposition in general. This is because when the heat treatment is performed, Schottky characteristics become impaired and a reverse leak current increases in some cases. However, when the metal electrode is in an only vapor-deposited state, a preferable electric contact of the metal/semiconductor layer cannot be obtained, which causes the reverse leak current to increase, or the metal film to peel-off.

### PRIOR ART DOCUMENT

### NON-PATENT DOCUMENTS

Non-patent document 1: "Highly Reliable 250W High Electron Mobility Transistor Power Amplifier", TOSHIHIDE KIKKAWA, Jpn. J. Appl. Phys. 44, (2005), 4896
Non-patent document 2: "Gallium Nitride Based High Power Heterojunction Field Effect Transistors: process Development and Present Status at USCB", Stacia Keller, Yi-Feng Wu, Giacinta Parish, Naiqian Ziang, Jane J. Xu, Bernd P. Keller, Steven P. DenBaars, and Umesh K. Mishra, IEEE Trans. Electron Devices 48, (2001), 552
Non-patent document 3: "Can InAlN/GaN be an alternative to high power/high temperature AlGaN/GaN devices?", F. Medjdoub, J.-F. Carlin, M. Gonschorek, E. Feltin, M.A. Py, D. Ducatteau, C. Gaquiere, N. Grandjean, and E. Kohn, IEEE IEDM Tech. Digest in IEEE IEDM 2006, 673

### SUMMARY OF THE INVENTION

The present invention was made in view of the above problems, and it is an object of the present invention to provide a semiconductor device in which a reverse leak current is suppressed, and a Schottky junction between a gate electrode and an epitaxial substrate is sufficiently reinforced.

In order to solve the above problems, according to a first aspect of the present invention, a semiconductor device includes an epitaxial substrate formed by laminating a group of group-III nitride layers on a base substrate in such a manner that (0001) crystal surfaces of the group-III nitride layers are substantially parallel to a substrate surface, and a Schottky electrode, in which the epitaxial substrate includes a channel layer formed of a first group-III nitride having a composition of Inₓ₁Al_{y1}Ga_{z1}N (x1 + y1 + z1 = 1, z1 > 0), a barrier layer formed of a second group-III nitride having a composition of Inₓ₂Al_{y2}N (x2 + y2 = 1, x2 > 0, y2 > 0), and a contact layer formed of a third group-III nitride having insularity and adjacent to the barrier layer, and the Schottky electrode is connected to the contact layer.

According to a second aspect of the present invention, as for the semiconductor device according to the first aspect, a bandgap of the second group-III nitride is larger than a bandgap of the first group-III nitride.

According to a third aspect of the present invention, as for the semiconductor device according to the first or second aspect, a bandgap of the third group-III nitride is larger than the bandgap of the second group-III nitride.

According to a fourth aspect of the present invention, as for the semiconductor device according to any one of the first to third aspects, the third group-III nitride is AlN.

According to a fifth aspect of the present invention, as for the semiconductor device according to any one of the first to fourth aspects, a Schottky junction between the Schottky electrode and the contact layer has been reinforced by a heat treatment under a nitrogen gas atmosphere.

According to a sixth aspect of the present invention, the semiconductor device according to the fifth aspect includes an interface layer formed between the Schottky electrode and the contact layer by the heat treatment.

According to a seventh aspect of the present invention, as for the semiconductor device according to the sixth aspect, the interface layer contains a constituent element of the contact layer and a constituent element of the Schottky electrode.

According to an eighth aspect of the present invention, as for the semiconductor device according to the sixth or seventh aspect, the Schottky electrode contains at least one of Ni, Pt, Pd, and Au, and the interface layer is formed in such a manner that at least one of Ni, Pt, Pd, and Au is soluble in the third group-III nitride.

According to a ninth aspect of the present invention, as for the semiconductor device according to any one of the first to eighth aspects, root-mean-square surface roughness of the contact layer is 0.5 nm or less.

According to a tenth aspect of the present invention, as for the semiconductor device according to the ninth aspect, a film thickness of the contact layer is 0.5 nm to 6 nm.

According to an eleventh aspect of the present invention, as for the semiconductor device according to any one of the first to tenth aspects, the second group-III nitride is Inₓ₂Al_{y2}N (x2 + y2 = 1, 0.14 ≤ x2 ≤ 0.24).

According to a twelfth aspect of the present invention, as for the semiconductor device according to any one of the first to eleventh aspects, the first group-III nitride is Al_{y1}Ga_{z1}N (y1 + z1 = 1, z1 > 0).

According to a thirteenth aspect of the present invention, as for the semiconductor device according to the twelfth aspect, the first group-III nitride is GaN.

According to a fourteenth aspect of the present invention, the semiconductor device according to the twelfth or thirteenth aspect, further includes a spacer layer formed of a fourth group-III nitride having a composition of Inₓ₄Al_{y4}Ga_{z4}N (x4 + y4 + z4 = 1, y4 > 0) and having a bandgap larger than that of the second group-III nitride, between the channel layer and the barrier layer.

According to a fifteenth aspect of the present invention, as for the semiconductor device according to the fourteenth aspect, the fourth group-III nitride is AlN.

According to a sixteenth aspect of the present invention, as for the semiconductor device according to any one of the first to fifteenth aspects, an ohmic electrode is connected to the same contact layer for the Schottky electrode.

According to a seventeenth aspect of the present invention, as for a HEMT deviceHEMT device serving as the semiconductor device according to the sixteenth aspect, the Schottky electrode is a gate electrode, and the ohmic electrode is a source electrode and a drain electrode.

According to an eighteenth aspect, a method of manufacturing a semiconductor device including an epitaxial substrate formed by laminating a group of group-III nitride layers on a base substrate in such a manner that (0001) crystal surfaces of the group-III nitride layers are substantially parallel to a substrate surface, and a Schottky electrode, includes a channel layer forming step of forming a channel layer with a first group-III nitride having a composition of Inₓ₁Alₓ₁Ga_{z1}N (x1 + y1 + z1 = 1, z1 > 0), on the base substrate, a barrier layer forming step of forming a barrier layer with a second group-III nitride having a composition of Inₓ₂Al_{y2}N (x2 + y2 = 1, x2 > 0, y2 > 0), on the channel layer, a contact layer forming step of forming a contact layer with a third group-III nitride having insularity so as to be adjacent to the barrier layer, and a Schottky electrode forming step of forming the Schottky electrode so as to be connected to the contact layer.

According to a nineteenth aspect of the present invention, as for the method of manufacturing the semiconductor device according to the eighteenth aspect, a bandgap of the second group-III nitride is larger than a bandgap of the first group-III nitride.

According to a twentieth aspect of the present invention, as for the method of manufacturing the semiconductor device according to the eighteenth or nineteenth aspect, bandgap of the third group-III nitride is larger than the bandgap of the second group-III nitride.

According to a twenty-first aspect of the present invention, as for the method of manufacturing the semiconductor device according to any one of the eighteenth to twentieth aspects, the third group-III nitride is AlN.

According to a twenty-second aspect of the present invention, the method of manufacturing the semiconductor device according to any one of the eighteenth to twenty-first aspects, further includes a heat treatment step of performing a heat treatment under a nitrogen gas atmosphere on the semiconductor device in which the Schottky electrode has been connected.

According to a twenty-third aspect of the present invention, as for the method of manufacturing the semiconductor device according to the twenty-second aspect, in the heat treatment step, an interface layer is formed between the Schottky electrode and the contact layer.

According to a twenty-fourth aspect of the present invention, as for the method of manufacturing the semiconductor device according to the twenty-third aspect, the interface layer contains a constituent element of the contact layer and a constituent element of the Schottky electrode.

According to a twenty-fifth aspect of the present invention, as for the method of manufacturing the semiconductor device according to the twenty-third or twenty-fourth aspect, in the Schottky electrode forming step, the Schottky electrode is formed so as to contain at least one of Ni, Pt, Pd, and Au, and in the heat treatment step, the interface layer is formed in such a manner that at least one of Ni, Pt, Pd, and Au is soluble in the third group-III nitride.

According to a twenty-sixth aspect of the present invention, as for the method of manufacturing the semiconductor device according to any one of the eighteenth to twenty-fifth aspects, the second group-III nitride is Inₓ₂Al_{y2}N (x2 + y2 = 1, 0.14 ≤ x2 ≤ 0.24).

According to a twenty-seventh aspect of the present invention, as for the method of manufacturing the semiconductor device according to any one of the eighteenth to twenty-sixth aspects, the first group-III nitride is Al_{y1}Ga_{z1}N (y1 + z1 = 1, z1 > 0).

According to a twenty-eighth aspect of the present invention, as for the method of manufacturing the semiconductor device according to the twenty-seventh aspect, the first group-III nitride is GaN.

According to a twenty-ninth aspect of the present invention, the method of manufacturing the semiconductor device according to the twenty-seventh or twenty-eighth aspect, further includes a spacer layer forming step of forming a spacer layer with a fourth group-III nitride having a composition of Inₓ₄Al_{y4}Ga_{z4}N (x4 + y4 + z4 = 1, y4 > 0) and having a bandgap larger than that of the second group-III nitride, between the channel layer and the barrier layer.

According to a thirtieth aspect of the present invention, as for the method of manufacturing the semiconductor device according to the twenty-ninth aspect, the fourth group-III nitride is AlN.

According to a thirty-first aspect of the present invention, the method of manufacturing the semiconductor device according to any one of the eighteenth to thirtieth aspects, further includes an ohmic electrode forming step of forming an ohmic electrode so as to be connected to the contact layer having the Schottky electrode thereon.

According to the first to thirty-first aspects of the present invention, the insulating contact layer is provided on the barrier layer, and the electrode is formed on the contact layer by the Schottky junction to form an MIS junction, whereby the semiconductor device in which the reverse leak current is suppressed is provided, compared to the case where the electrode is directly formed on the barrier layer by the Schottky junction.

In addition, according to the fifth to eighth and twenty-second to twenty-fifth aspects of the present invention, the heat treatment is performed under the nitrogen atmosphere after the electrode has been formed by the Schottky junction, whereby the Schottky-junction electrode is reinforced and is prevented from peeling-off. Thus, the semiconductor device having high reliability can be stably provided.

Especially, according to the sixth to eighth and twenty-third to twenty-fifth aspects of the present invention, since the interface layer is formed by the heat treatment, the Schottky-junction electrode is further reinforced and prevented from peeling-off.

### BRIEF DESCRIPTION OF THE DRAWINGS

Fig. 1 is a schematic cross-sectional view schematically showing a configuration of a HEMT device 20 serving as one aspect of a semiconductor device according to an embodiment of the present invention.
Fig. 2 is a view provided by plotting surface roughness of a contact layer 6 with respect to its thickness.
Fig. 3 is a view provided by plotting a reverse leak current with respect to the thickness of the contact layer 6.
Fig. 4 is a view provided by plotting contact resistance of an ohmic electrode with respect to the thickness of the contact layer 6.
Fig. 5 is a view showing a depth profile of a HEMT device 20 obtained by measurement of Auger electron spectroscopy.

### EMBODIMENT FOR CARRYING OUT THE INVENTION

### <Configuration of HEMT device>

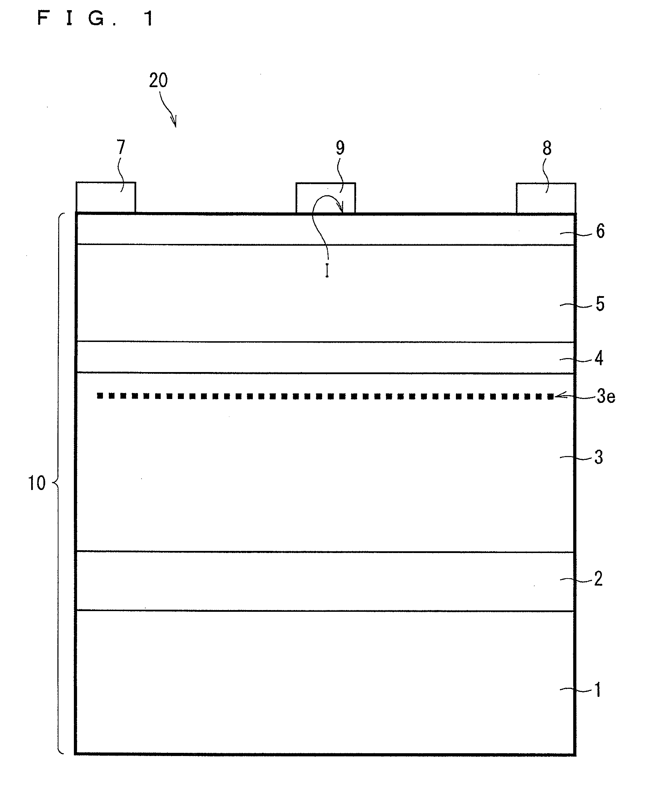

FIG. 1 is a schematic cross-sectional view schematically showing the configuration of a HEMT device 20 serving as one aspect of a semiconductor device according to an embodiment of the present invention. The HEMT device 20 has a configuration in which a source electrode 7, a drain electrode 8, and a gate electrode 9 are formed on an epitaxial substrate 10. More specifically, the epitaxial substrate 10 has a configuration in which a base substrate 1, a buffer layer 2, a channel layer 3, a spacer layer 4, a barrier layer 5, and a contact layer 6 are formed by lamination. Thus, the source electrode 7, the drain electrode 8, and the gate electrode 9 are formed on the contact layer 6. Note that ratios of thickness of the respective layers in FIG. 1 do not reflect actual ones. The buffer layer 2, the channel layer 3, the spacer layer 4, the barrier layer 5, and the contact layer 6 are preferred examples of layers that are epitaxially formed using a MOCVD (metalorganic chemical vapor deposition) method (a detail will be described below).

Hereinbelow, while description is given of a case where the MOCVD method is used for the formation of each layer, other epitaxial growth technique, for example, the technique appropriately selected from various vapor phase growth methods and liquid phase growth methods such as MBE, HVPE and LPE may be used as long as it is the technique capable of forming each layer for providing excellent crystallinity. Alternatively, different growth methods may be used in combination.

Any substrate may be used as the base substrate 1 as long as a nitride semiconductor layer having excellent crystallinity can be formed thereon, without any particular limitation. A 6H-SiC single crystal substrate is preferably used as an example, and a substrate composed of sapphire, Si, GaAs, spinel, MgO, ZnO, ferrite or the like may be used.

The buffer layer 2 is formed of AlN to have a thickness of approximately several hundreds of nm, for making crystal quality of the channel layer 3, the spacer layer 4, the barrier layer 5, and the contact layer 6 that are formed thereon excellent. For example, the buffer layer 2 is preferably formed to have a thickness of 200 nm.

The channel layer 3 is formed of a group-III nitride (first group-III nitride) having a composition of Inₓ₁Al_{y1}Ga_{z1}N (x1+y1+z1=1) so as to have a thickness of approximately several µm. The channel layer 3 is preferably formed of a group-III nitride having a composition of Al_{y1}Ga_{z1}N (y1+z1=1, z1>0), and is more preferably formed of GaN.

On the other hand, the barrier layer 5 is formed of a group-III nitride (second group-III nitride) having a composition of Inₓ₂Al_{y2}N (x2+y2=1, x2>0, y2>0) so as to have a thickness of several nm to several tens of nm. Preferably, 0.14≤x2≤0.24. A value of x2 outside this range is not preferable because strains exerted on the barrier layer 5 exceed ±0.5%, leading to a larger influence of crystal strains on the reliability of schottky junction.

Furthermore, the channel layer 3 and the barrier layer 5 are formed so as to satisfy a composition range in which a bandgap of the second group-III nitride constituting the latter is larger than a band gap of the first group-III nitride constituting the former.

In addition, the contact layer 6 is formed of a group-III nitride (third group-III nitride) having insularity. In this embodiment, the term "the group-III nitride having insularity" means that specific resistance is 10⁸Ωcm or more. As long as the specific resistance is in that range, an MIS junction to be described below can be preferably formed. As long as the above specific resistance is fulfilled, existence of a conductive impurity is allowed. As for the contact layer 6, its composition is selected so as to satisfy the relationship in which the third group-III nitride has a bandgap larger than the second group-III nitride. Preferably, the contact layer 6 is formed of AlN. A function effect provided because the HEMT device 20 has the contact layer 6 will be described below.

Furthermore, the spacer layer 4 is provided between the channel layer 3 and the barrier layer 5. The spacer layer 4 is formed of a group-III nitride (fourth group-III nitride) that has a composition of Inₓ₄Al_{y4}Ga_{z4}N (x4 + y4 + z4 = 1) and contains at least Al so as to have a thickness in a range of 0.5 nm to 1.5 nm.

In the epitaxial substrate 10 having the above-mentioned layer configuration, a two-dimensional electron gas region 3e in which two-dimensional electron gas is present at high concentration is formed at an interface between the channel layer 3 and the spacer layer 4 (more specifically, at a portion of the channel layer 3 in the vicinity of the interface).

Preferably, the spacer layer 4 and the barrier layer 5 are formed such that a bandgap of the group-III nitride constituting the former satisfies the composition range of becoming equal to or more than a bandgap of the group-III nitride constituting the latter. In such a case, an alloy scattering effect is suppressed, leading to improved concentration as well as mobility of two-dimensional electron gas. The spacer layer 4 is more preferably formed of AlN (x4=0, y4=1, z4=0). In such a case, the spacer layer 4 is a binary compound of Al and N, and thus an alloy scattering effect is suppressed further compared with the case of a ternary compound containing Ga, with the result that the concentration and mobility of two-dimensional electron gas are improved. Note that the discussion regarding the above-mentioned composition range does not exclude the fact that the spacer layer 4 contains impurities.

Note that the epitaxial substrate 10 is not necessarily required to include the spacer layer 4, and the barrier layer 5 may be formed directly on the channel layer 3. In such a case, the two-dimensional electron gas region 3e is formed at the interface between the channel layer 3 and the barrier layer 5.

Each of the source electrode 7 and the drain electrode 8 is a multilayered metal electrode in which its metal layer has a thickness of about a dozen nm to a hundred and several tens of nm, and is in ohmic contact with the contact layer 6. A metal used for the source electrode 7 and the drain electrode 8 may be a metal material by which a preferable ohmic contact with the epitaxial substrate 10 (with contact layer 6) can be obtained. It is preferable that the multilayered metal electrode constituted of Ti/Al/Ni/Au is used for the source electrode 7 and the drain electrode 8, but the material is not limited to this, and the multilayered metal electrode constituted of Ti/Al/Pt/Au or Ti/Al may be formed. The source electrode 7 and the drain electrode 8 can be formed by a photolithography process and a vacuum vapor deposition method.

Meanwhile, the gate electrode 9 is a single-layered or multilayered metal electrode in which one or more metal layers are formed to be about a dozen nm to a hundred and several tens of nm thick, and has Schottky contact with the barrier layer 5. The gate electrode 9 is preferably formed of a metal having a high work function such as Pd, Pt, Ni, or Au as a formation material. Alternatively, it may be formed as a multilayered metal film constituted of above metals, or constituted of the above metal and Al or the like. Besides, in a case where the contact layer 6 is formed of AlN, in addition to the above, a metal material which is used when the ohmic junction is formed with the group-III nitride semiconductor such as a multilayer metal film containing Ti/Al can be used as the formation material of the gate electrode 9. This is because, since AlN having a large band gap is connected to a metal material having a relatively low work function in this case, a Schottky contact can be obtained with relative ease. The gate electrode 9 can be formed by a photolithography process and a vacuum vapor deposition method.

### <Schottky junction between contact layer and gate electrode>

According to the HEMT device 20 having the above configuration, what is called the MIS (metal-insulator-semiconductor) junction is formed by the gate electrode 9, the contact layer 6, and the barrier layer 5. Since the MIS junction is provided, as for the HEMT device 20, a reverse leak current is suppressed in principle, compared to a conventional HEMT device in which the gate electrode 9 is in direct Schottky junction with the barrier layer 5. Although a specific value differs depending on a composition or a thickness of each part, in the case where the HEMT device 20 is constituted according to this embodiment, a leak current provided when a voltage such as -100 V is applied can be suppressed to 1/100 to 1/1000 of the case where the gate electrode is directly formed on the barrier layer.

Moreover, a thickness of the contact layer 6 is preferably set to 0.5 nm to 6 nm. When the thickness is 0.5 nm or more, an effect of reduction of the leak current can be provided. In addition, a surface of the contact layer 6 is flatter than a surface of the barrier layer 5. Meanwhile, an upper limit of the thickness of the contact layer 6 may be determined to the extent that the formation of the source electrode 7 and the drain electrode 8 serving as the ohmic electrodes on the contact layer 6 does not affect contact resistance. For example, the thickness of the contact layer 6 is preferably 6 nm or less.

From another standpoint, the HEMT device 20 according to this embodiment is characterized in that the contact layer 6 is wholly formed on the barrier layer 5, so that it is uniformly provided not only just under the gate electrode 9 but also just under the source electrode 7 and the drain electrode 8. Originally, as long as the contact layer 6 is formed only just under the gate electrode 9, the function effect to reduce the reverse leak current can be obtained, but a photolithography process and an etching process is needed to implement the above configuration, which causes high costs. According to this embodiment, since the contact layer 6 is just wholly formed on the barrier layer 5, the above process is not performed, so that HEMT device superior in characteristics can be realized at low costs.

### <Method for manufacturing HEMT device>

Next, the method of manufacturing the HEMT device 20 having the above-mentioned configuration is described.

First of all, the epitaxial substrate 10 can be manufactured with a known MOCVD reactor. Specifically, there is used an MOCVD reactor configured such that a reactor is capable of being supplied with a metal organic (MO) source gas (TMI, TMA and TMG) for In, Al and Ga, an ammonia gas, a hydrogen gas and a nitrogen gas.

At first, a 6H-SiC substrate that has (0001) plane orientation and a diameter of two inches is prepared as the base substrate 1, for example, and the base substrate 1 is placed on a susceptor provided in the reactor of the MOCVD reactor. The inside of the reactor is replaced with vacuum gas, and then, an atmosphere in hydrogen/nitrogen mixed flow state is formed while maintaining a pressure inside the reactor at a predetermined value of 5 kPa to 50 kPa. After that, the temperature of the substrate is raised through susceptor heating.

When the susceptor temperature reaches a predetermined temperature of 950°C to 1,250°C (for example, 1,050°C), which is a buffer layer forming temperature, Al source gas and NH₃ gas are introduced into the reactor, to thereby form an AlN layer serving as the buffer layer 2.

After the AlN layer is formed, the susceptor temperature is maintained at a predetermined channel layer forming temperature, and metal organic source gas and ammonia gas are introduced into the reactor in accordance with the composition of the channel layer 3, thereby forming an Inₓ₁Al_{y1}Ga_{z1}N layer (where x1=0, 0≤y1≤0.3) serving as the channel layer 3. Here, a channel layer forming temperature T1 is a value determined in the temperature range of 950°C or more to 1,250°C or less in accordance with a value of an AlN mole fraction y1 of the channel layer 3. Note that the pressure in reactor when forming the channel layer 3 is not particularly limited, and can be appropriately selected from the range of 10 kPa to an atmospheric pressure (100 kPa).

After the formation of the Inₓ₁Al_{y1}Ga_{z1}N layer, the inside of the reactor is maintained at the nitrogen gas atmosphere while keeping the susceptor temperature, and the reactor pressure is set to 10 kPa. After that, metal organic source gas and ammonia gas are introduced into the reactor, whereby an Inₓ₄Al_{y4}Ga_{z4}N layer serving as the spacer layer 4 is formed to have a predetermined thickness.

After the formation of the Inₓ₄Al_{y4}Ga_{z4}N, in order to form an Inₓ₂Al_{y2}N layer serving as the barrier layer 5, the susceptor temperature is kept at a predetermined barrier layer forming temperature of 650°C or more and 800°C or less so that the pressure in reactor is maintained at a predetermined value between 1 kPa and 30 kPa. Then, ammonia gas and metal organic source gas of a flow rate corresponding to the composition of the barrier layer 5 are introduced into the reactor so that a so-called V/III ratio takes a predetermined value of 3,000 or more and 20,000 or less.

After the formation of the Inₓ₄Al_{y4}Ga_{z4}N layer, the susceptor temperature is set to a predetermined contact layer formation temperature, and a flow ratio of the metal organic source gas is adjusted according to a composition of the contact layer 6, whereby the contact layer 6 is formed to have a predetermined thickness. The manufacturing of the epitaxial substrate 10 terminates at the time when the formation of the contact layer 6 is finished. As described above, the contact layer 6 only has to have the specific resistance of 10⁸ Ωcm or more, and it does not necessarily have high crystallinity, so that the contact layer formation temperature may be the same as the barrier layer formation temperature or more. When the contact layer 6 is formed so as to have sufficient crystallinity and higher specific resistance, the contact layer formation temperature is preferably set to a temperature of 1050°C to 1200°C.

After the epitaxial substrate 10 has been formed, the HEMT device is formed using this. Each following step is implemented by a well-known method.

First, a multilayered metal pattern serving as the source electrode 7 and the drain electrode 8 is formed in a target position of the contact layer 6 by a photolithography process and a vacuum vapor deposition method.

Then, in order to improve an ohmic property of the source electrode 7 and the drain electrode 8, the epitaxial substrate 10 on which the source electrode 7 and the drain electrode 8 has been formed is subjected to a heat treatment at a predetermined temperature of 650°C to 1000°C in a nitrogen gas atmosphere for several tens of seconds.

Then, a multilayered metal pattern serving as the gate electrode 9 is formed in a target position of the contact layer 6 by a photolithography process and a vacuum vapor deposition method.

Then, the epitaxial substrate 10 is cut into lots of chips each having a predetermined size by dicing, so that lots of HEMT devices 20 are provided. The provided HEMT device 20 is treated by die bonding or wire bonding accordingly.

### <Suppression of electrode peeling due to heat treatment>

The HEMT device 20 in which the reverse leak current is suppressed is provided in the above manner, and preferably, the HEMT device 20 is further subjected to a heat treatment in a manufacturing process under a nitrogen atmosphere in order to reinforce the junction of the gate electrode 9 (to prevent the gate electrode 9 from peeling-off).

More specifically, the HEMT device 20 after the gate electrode 9 has been formed is subjected to the heat treatment at a predetermined temperature between 500°C to 900°C in a nitrogen gas atmosphere for several tens of seconds.

In the case where the lots of HEMT devices 20 are manufacutured from one mother substrate at the same time, that is, what is called multi-work processing is performed, assuming that a ratio of the HEMT device 20 in which the gate electrode 9 has peeled off is set to a peeled-off ratio, the peeled-off ratio in the case where the heat treatment is not performed is 30% at lowest and reaches up to 70% or more, depending on a formation material of the gate electrode 9. Meanwhile, in the case where the gate electrode 9 is formed of the same formation material and subjected to the heat treatment, the peeled-off ratio is roughly 0%. This is because an interface layer at a junction interface surface I between the barrier layer 5 and the gate electrode 9, which is formed by diffusion and solid solution of the electrode metal material to the barrier layer 5 with the heat treatment, contributes to improving adhesiveness between both of them. That is, the above heat treatment may be regarded as a step of forming the interface layer.

Meanwhile, even when the heat treatment is performed as described above, the reverse leak current is still suppressed at the same degree as the case where the heat treatment is not performed. This means that due to the heat treatment, the gate electrode 9 can be in Schottky junction with the barrier layer 5 at a sufficient junction intensity, and the HEMT device 20 having the sufficiently small reverse leak current is provided at high yield.

As described above, according to this embodiment, the insulating contact layer is provided on the barrier layer, the gate electrode is formed on the contact layer with Schottky junction so as to form MIS junction, whereby the HEMT device in which the reverse leak current is considerably reduced is provided, compared to the case where the gate electrode is directly formed on the barrier layer by the Schottky junction. In addition, by performing the heat treatment under the nitrogen atmosphere after forming the gate electrode, the gate electrode can be prevented from peeling off, so that the HEMT device superior in Schottky characteristics can be stably obtained.

### <Variation>

In the above embodiment, a description has been made of the HEMT device as a target, but the aspect that the MIS junction is formed between the gate electrode and the barrier layer can be similarly applied to another electronic device using the Schottky junction, such as a Schottky barrier diode or photo sensor.

### Examples

### (Example 1)

In this example, as the HEMT device 20 according to the above embodiment, 24 types of HEMT devices were manufactured by differentiating combinations of three manufacturing conditions such as the composition of the barrier layer 5, the configuration of the gate electrode 9, and whether or not to perform the heat treatment for the gate electrode 9. For each type, 50 HEMT devices were manufactured from one mother substrate. Then, the peeled-off ratio of the gate electrode 9, and the reverse leak current were evaluated for each type of the HEMT devices 20 manufactured as above. The manufacturing condition specific to each HEMT device 20, the peeled-off ratio of the gate electrode, and a result of reverse leak current measurement when -100 V was applied are shown in table 1 as a list.

First of all, the epitaxial substrates 10 for the respective HEMT devices 20 were prepared. In this preparation, the same manufacturing condition was applied to all epitaxial substrates 10 until their spacer layers 4 were formed.

Specifically, at first, a plurality of 6H-SiC substrates that have (0001) plane orientation and a diameter of two inches were prepared as the base substrate 1. A thickness of the substrates was 300 µm. Each of the substrates was placed in a reactor of an MOCVD reactor, and an inside of the reactor was replaced with vacuum gas. After that, a pressure in reactor was set to 30 kPa, thereby forming the atmosphere in hydrogen/nitrogen mixed flow state. Then, a temperature of the base substrate 1 was raised through susceptor heating.

When a susceptor temperature reached 1,050°C, TMA bubbling gas and ammonia gas were introduced into the reactor, to thereby form an AlN layer that serves as the buffer layer and has a thickness of 200 nm.

Then, the susceptor temperature was set to a predetermined temperature, and TMG bubbling gas as metal organic source gas and ammonia gas were introduced into the reactor at a predetermined flow rate, thereby forming a GaN layer having a thickness of 2 µm as the channel layer.

After the channel layer was obtained, the reactor pressure was set to 10 kPa, and then TMA bubbling gas and ammonium gas were introduced into the reactor, thereby forming the AlN layer serving as the spacer layer to have a thickness of 1 nm.

After the formation of the spacer layer, next, the barrier layer 5 was formed. Composition of the barrier layer 5 was differentiated in three levels such as In_{0.14}Al_{0.86}N, In_{0.18}Al_{0.82}N, and In_{0.24}Al_{0.76}N. In this regard, the susceptor temperatures for the respective samples were set in 770°C, 745°C, and 720°C. In addition, a thickness of barrier layer 5 was set in 15 nm for all samples.

After the formation of the barrier layer 5, the susceptor temperature was set to 1050°C again to form an AlN layer having a thickness of 3 nm as contact layer 6. That is, the manufacturing condition of the contact layer 6 was the same for all the HEMT devices 20. It has been previously confirmed that specific resistance of the contact layer 6 formed as described above is about 10¹⁵ Ωcm, and the AlN layer has insularity (the same is applied to the following examples).

After the formation of the contact layer 6, the susceptor temperature was lowered to about room temperature, the pressure in the reactor was set back to atmospheric pressure, and then the manufactured epitaxial substrates 10 were taken out. Thus, through the above procedure, the respective epitaxial substrates 10 were obtained.

Then, an electrode pattern of Ti/Al/Ni/Au (respective film thicknesses were 25/75/15/100 nm) was formed in target positions of the source electrode 7 and the drain electrode 8 on the upper surface of the contact layer 6 by a photolithography process and a vacuum vapor deposition method. After that, a heat treatment was performed in nitride atmosphere, at 800°C for 30 seconds.

Furthermore, a pattern of the gate electrode 9 was formed in a target position of the gate electrode 9 on the upper surface of the contact layer 6 by a photolithography process and a vacuum vapor deposition method. As the gate electrodes 9, four types including three types of multilayered metal electrodes of Ni/Au (film thickness 6 nm/12 nm), Pd/Au (6 nm/12 nm), and Pt/Au (6 nm/12 nm), and single-layer electrode (12 nm) consisted of only Au were formed. At this time, the gate electrode 9 was formed so that its junction part with the contact layer 6 had a size of 1 mm × 1 mm.

After the fomation of the pattern of the gate electrode 9, a heat treatment was performed for only the HEMT devices 20 where it had been determined that the heat treatment for the gate electrodes 9 were performed.

Finally, with cutting into chips by dicing, the 50 HEMT devices 20 were provided.

As for the provided HEMT devices 20, whether or not the gate electrode 9 had peeled-off was evaluated visually and microscopically, and the peeled-off ratio was calculated as the ratio of the number of the HEMT devices 20 in which the gate electrode 9 had peeled-off to the number of 50 which was the total of HEMT devices 20. In addition, after die bonding and wire bonding were performed, the reverse leak current when -100 V was applied was measured. Thus, the result shown in the table 1 was obtained. In this result, the reverse leak current shows an average value of the measurement results obtained from the HEMT devices 20 in which the gate electrode 9 was not peeled-off.

### (Comparative Example)

As a comparative example, 24 types of HEMT devices were manufactured under the same manufacturing conditions as the HEMT device 20 in the example 1 except that the contact layer 6 was not provided and the source electrode 7, the drain electrode, and the gate electrode 9 were directly formed on the upper surface of the barrier layer 5. A table 2 shows a specific manufacturing condition, a peeled-off ratio, and an evaluation result of a reverse leak current for the HEMT devices according to the comparative example as a list.

**[TABLE 1]**

| CONFIGURATION OF EPITAXIAL SUBSTRATE | GATE ELECTRODE CONFIGURATION | HEAT TREATMENT PERFORMED OR NOT PERFORMED | GATE ELECTRODE PEELED-OFF RATIO | LEAK CURRENT (A) (WHEN -100 V IS APPLIED) |
|---|---|---|---|---|
| BARRIER LAYER:In_{0.14}Al_{0.86}N | Ni/Au | NOT PERFORMED | 34% | 8.10E-09 |
| | Pd/Au | | 52% | 9.40E-09 |
| | Pt/Au | | 62% | 1.30E-08 |
| CONTACT LAYER: AlN (THICKNESS: 3 nm) | Au | | 48% | 6.60E-09 |
| | Ni/Au | PERFORMED | 0% | 2.50E-08 |
| | Pd/Au | | 0% | 1.50E-08 |
| | Pt/Au | | 0% | 1.50E-08 |
| | Au | | 0% | 1.20E-08 |
| BARRIER LAYER:In_{0.18}Al_{0.86}N | Ni/Au | NOT PERFORMED | 48% | 7.30E-09 |
| | Pd/Au | | 30% | 8.50E-09 |
| | Pt/Au | | 42% | 1.20E-08 |
| CONTACT LAYER: AlN (THICKNESS: 3 nm) | Au | | 74% | 6.50E-09 |
| | Ni/Au | PERFORMED | 0% | 9.40E-09 |
| | Pd/Au | | 0% | 1.10E-08 |
| | Pt/Au | | 0% | 6.80E-09 |
| | Au | | 0% | 8.90E-09 |
| BARRIER LAYER:In_{0.24}Al_{0.86}N | Ni/Au | NOT PERFORMED | 52% | 1.50E-08 |
| | Pd/Au | | 40% | 1.10E-08 |
| | Pt/Au | | 36% | 8.30E-09 |
| CONTACT LAYER: AlN (THICKNESS: 3 nm) | Au | | 64% | 7.20E-09 |
| | Ni/Au | PERFORMED | 0% | 9.70E-09 |
| | Pd/Au | | 0% | 8.50E-09 |
| | Pt/Au | | 0% | 1.10E.08 |
| | Au | | 0% | 1.30E-08 |

**[TABLE 2]**

| CONFIGURATION OF EPITAXIAL SUBSTRATE | GATE ELECTRODE CONFIGURATION | HEAT TREATMENT PERFORMED OR NOT PERFORMED | GATE ELECTRODE PEELED-OFF RATIO | LEAK CURRENT (A) (WHEN -100 V IS APPLIED) |
|---|---|---|---|---|
| BARRIER LAYER:In_{0.14}Al_{0.86}N | Ni/Au | NOT PERFORMED | 44% | 1.50E-06 |
| | Pd/Au | | 22% | 1.20E-05 |
| | Pt/Au | | 42% | 1.20E-05 |
| CONTACT LAYER: AlN (THICKNESS: 3 nm) | Au | | 70% | 6.40E-06 |
| | Ni/Au | PERFORMED | 0% | 1.20E-02 |
| | Pd/Au | | 0% | 1.30E-03 |
| | Pt/Au | | 0% | 8.20E-03 |
| | Au | | 0% | 4.40E-03 |
| BARRIER LAYER:In_{0.18}Al_{0.82}N | Ni/Au | NOT PERFORMED | 28% | 1.50E-06 |
| | Pd/Au | | 34% | 2.30E-06 |
| | Pt/Au | | 30% | 1.20E-06 |
| CONTACT LAYER: AlN (THICKNESS: 3 nm) | Au | | 44% | 5.60E-06 |
| | Ni/Au | PERFORMED | 0% | 1.50E-03 |
| | Pd/Au | | 0% | 3.40E-03 |
| | Pt/Au | | 0% | 2.50E-03 |
| | Au | | 0% | 2.60E-03 |
| BARRIER LAYER:In_{0.24}Al_{0.76}N | Ni/Au | NOT PERFORMED | 52% | 1.10E-05 |
| | Pd/Au | | 28% | 1.50E-06 |
| | Pt/Au | | 20% | 3.70E-06 |
| CONTACT LAYER: AlN (THICKNESS: 3 nm) | Au | | 38% | 1.00E-07 |
| | Ni/Au | PERFORMED | 0% | 5.30E-03 |
| | Pd/Au | | 0% | 6.70E-03 |
| | Pt/Au | | 0% | 3.30E-03 |
| | Au | | 0% | 1.10E-03 |

### (Comparison between Example 1 and Comparrative Example)

From the result shown in the table 1 and table 2, it has been found that the reverse leak current of all types of the HEMT devices 20 according to the Example 1 is suppressed to 1/100 to 1/1000 of the reverse leak current of the HEMT devices according to the Comparative Example manufactured under the same condition except for the contact layer 6. This result shows that the formation of the contact layer 6 is effective in reducing the reverse leak current.

In addition, although there is a slight difference depending on the kind of the formation material of the gate electrode 9, as for the HEMT device 20 in which the heat treatment was not performed after the gate electrode 9 was formed, the contact layer 9 has peeled-off at a relatively high ratio in each of the Example 1 and the Comparative Example. The peeled-off ratio is about 20 to 30% at lowest and reaches up to 70% or more. Meanwhile, as for the HEMT device 20 subjected to the heat treatment, the peeling-off is not recognized at all, regardless of which electrode formation material is used.

However, in the Comparative Example, the reverse leak current is in the order of 10⁻⁵ to 10⁻⁶ A in the case where the heat treatment was not performed, but it considerably increases to in the order of 10⁻² to 10⁻³ A in the case where the heat treatment was performed

This means that when the heat treatment is performed on the HEMT device not provided with the contact layer 6 after the gate electrode has been formed, the effect of preventing the gate electrode from peeling-off can be obtained, but the reverse leak current considerably increases, so that the object of obtaining the HEMT device superior in Schottky junction characteristics cannot be attained.

Meanwhile, according to the Example 1, regardless of the kind of the formation material of the gate electrode 9, the reverse leak current of the HEMT device 20 which was not subjected to the heat treatment is in the order of 10⁻⁸ to 10⁻⁹ A which is considerably smaller than that of the Comparative Example, and the value is hardly changed as for the HEMT device 20 which was subjected to the heat treatment.

The above result shows that the HEMT device in which the reverse leak current is considerably suppressed can be realized by providing the contact layer on the barrier layer, and the gate electrode comes in Schottky junction with the contact layer to form the MIS junction like the HEMT device according to the Example 1, compared to the HEMT device in which the gate electrode is directly in Schottky junction with the barrier layer, and the gate electrode can be almost surely prevented from peeling-off by performing the heat treatment after the gate electrode has been formed.

### (Example 2)

According to this example, the HEMT devices 20 in which the thicknesses of the contact layers 6 were variously differentiated were manufacrured, including the case where the contact layer 6 is not provided. More specifically, the HEMT devices were manufactured in the same procedure as the Example 1 except that the thicknesses of the contact layers 6 was set to eight levels of 0 nm, 0.1 nm, 0.5 nm, 1.5 nm, 3 nm, 6 nm, 8 nm, and 10 nm, that the gate electrode 9 was formed of only Ni/Au (film thickness 6 nm/12 nm), and that the heat treatment after the gate electrode was formed was performed to all devices.

In addition, in the process of manufacturing the HEMT device, when the epitaxial substrate 10 was obtained, surface roughness (RMS value) of the contact layer 6 was measured with an AFM (atomic force microscope). A measurement area was set to 3 µm × 3 µm.

In addition, as for the obtained HEMT device, the reverse leak current was measured similar to the first working example.

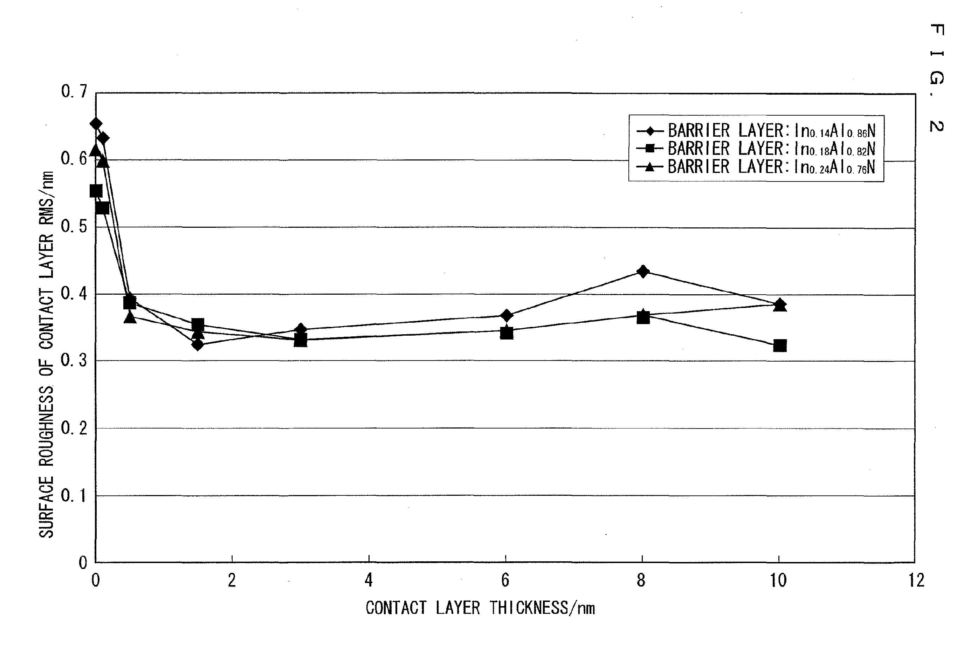

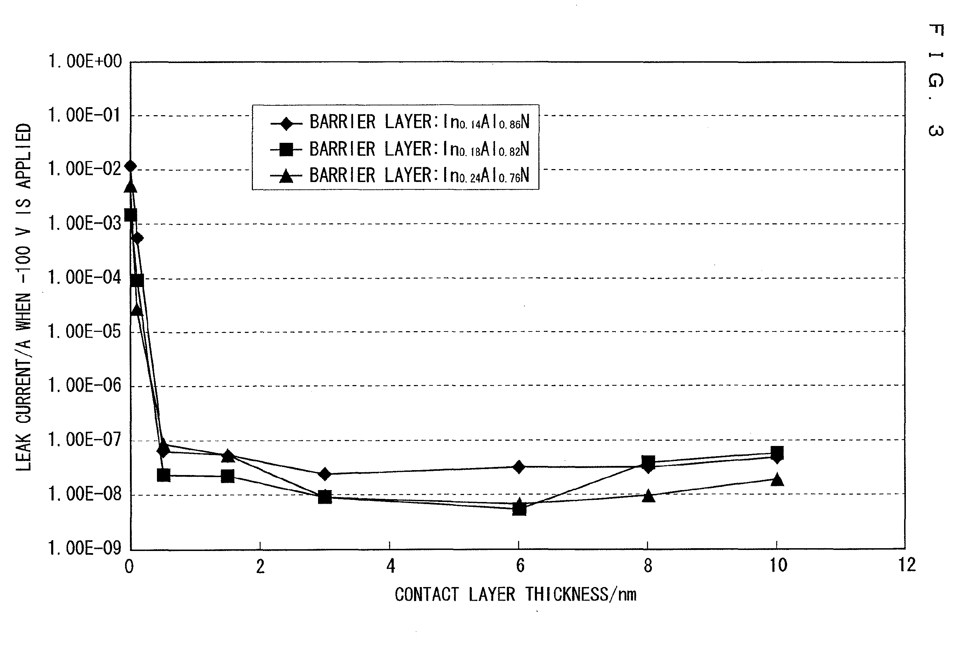

Fig. 2 is a view provided by plotting the surface roughness of the contact layer 6 with respect to its thickness. In addition, Fig. 3 is a view provided by plotting the reverse leak current with respect to the thickness of the contact layer 6.

Comparing Fig. 2 with Fig. 3, in each case, the value is maximum when the thickness of the contact layer 6 is 0 nm (that is, when the contact layer 6 is not provided), the value suddenly falls until the thickness of the contact layer 6 reaches 0. 5 nm, and is almost flat when being 0.5 nm or more with a smaller value than the case of 0 nm. This means that by forming the contact layer 6 to be 0.5 nm or more thick, its surface flatness is improved, and that by providing the gate electrode 9 on the contact layer 6 superior in a surface flatness, the reverse leak current is reduced.

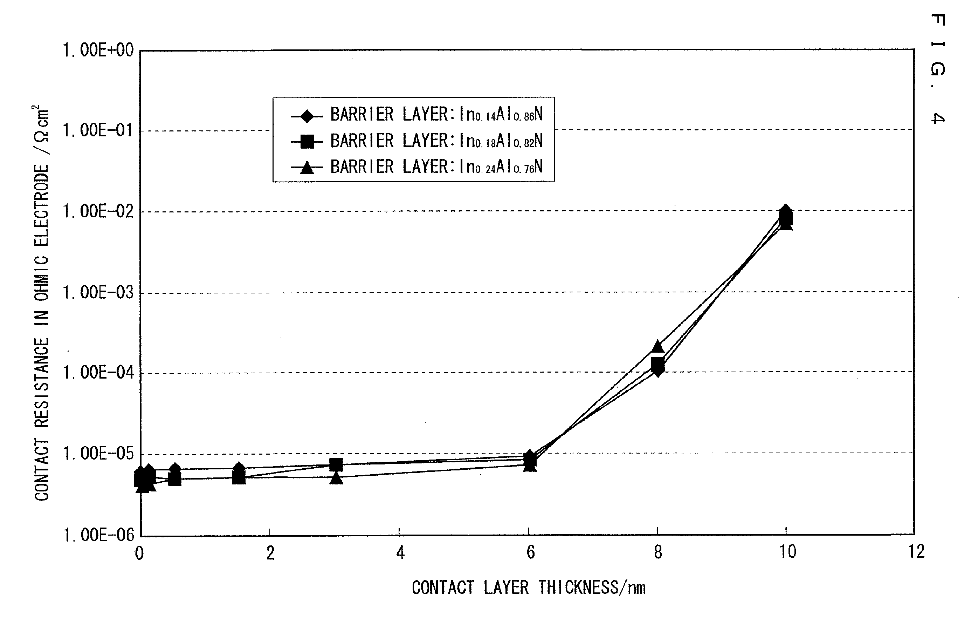

Furthermore, the contact resistance in the ohmic electrode (source electrode 7 and the drain electrode 8) was measured in respective HEMT devices. Fig. 4 is a view provided by plotting the obtained contact resistance with respect to the thickness of the contact layer 6.

From Fig. 4, it is seen that while the contact resistance is almost constant such as 1.0 × 10⁻⁵/Ωcm² or less in a range where the thickness of the contact layer 6 is 6 nm or less, the contact resistance abruptly increases in a range where the thickness of the contact layer 6 exceeds 6 nm. This result shows that the thickness of the contact layer 6 is preferably 6 nm or less in a point of view of keeping the contact resistance of the ohmic electrode at a sufficiently low value.

### (Third working example)

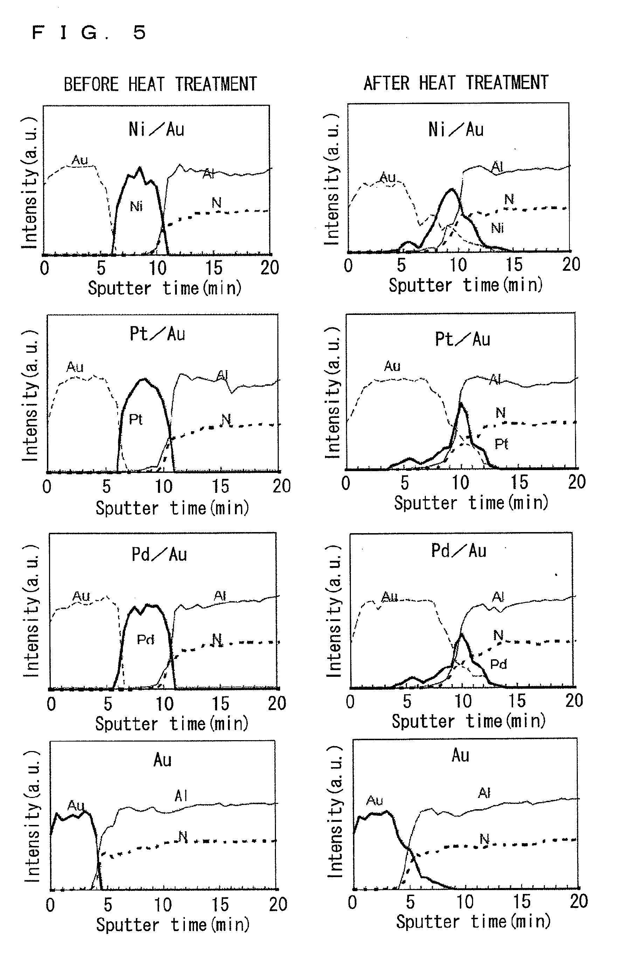

Among the HEMT devices according to the Example 1, as for the ones whose the composition of the barrier layer 5 are In_{0.18}Al_{0.82}N, including the one to which the heat treatment was performed and the one to which not performed, depth profiles of main elements were measured by Auger electron spectroscopy. Fig. 5 is a view showing the depth profiles obtained by the above measurement. In Fig. 5, the profiles for devices to which the heat treatment was performed are shown as "after heat treatment", and profiles for devices to which the heat treatment was not performed are shown as "before heat treatment". The result shown in Fig. 5 clearly shows that by performing the heat treatment, the metal elements (Ni/Au, Pt/Au, Pd/Au, Au) constituting the gate electrode 9 are diffused and soluble in the vicinity of the AlN surface, and the interface layer is formed in the junction interface I between both of them. This result suggests that the formation of the interface layer by the heat treatment contributes to the prevention of the peeling-off of the gate electrode 9.

### EXPLANATION OF REFERENCES

| | |
|---|---|
| 1 | BASE SUBSTRATE |
| 2 | BUFFER LAYER |
| 3 | CHANNEL LAYER |
| 3E | TWO-DIMENSIONAL ELECTRON GAS REGION |
| 4 | SPACER LAYER |
| 5 | BARRIER LAYER |
| 6 | CONTACT LAYER |
| 7 | SOURCE ELECTRODE |
| 8 | DRAIN ELECTRODE |
| 9 | GATE ELECTRODE |
| 10 | EPITAXIAL SUBSTRATE |
| 20 | HEMT ELEMENT |
| I | JUNCTION INTERFACE |

## Claims

1. A semiconductor device comprising:
an epitaxial substrate, formed by laminating a group of group-III nitride layers on a base substrate in such a manner that (0001) crystal surfaces of said group-III nitride layers are substantially parallel to a substrate surface; and
a Schottky electrode, wherein
said epitaxial substrate comprises:
a channel layer formed of a first group-III nitride having a composition of Inₓ₁Al_{y1}Ga_{z1}N (x1 + y1 + z1 = 1, z1 > 0);
a barrier layer formed of a second group-III nitride having a composition of Inₓ₂Al_{y2}N (x2 + y2 = 1, x2 > 0, y2 > 0); and
a contact layer formed of a third group-III nitride having insularity and adjacent to said barrier layer, and
said Schottky electrode is connected to said contact layer.

2. The semiconductor device according to claim 1, wherein
a bandgap of said second group-III nitride is larger than a bandgap of said first group-III nitride.

3. The semiconductor device according to claim 1 or 2, wherein
a bandgap of said third group-III nitride is larger than the bandgap of said second group-III nitride.

4. The semiconductor device according to any one of claims 1 to 3, wherein
said third group-III nitride is AlN.

5. The semiconductor device according to any one of claims 1 to 4, wherein
a Schottky junction between said Schottky electrode and said contact layer has been reinforced by a heat treatment under a nitrogen gas atmosphere.

6. The semiconductor device according to claim 5, comprising an interface layer formed between said Schottky electrode and said contact layer by said heat treatment.

7. The semiconductor device according to claim 6, wherein
said interface layer contains a constituent element of said contact layer and a constituent element of said Schottky electrode.

8. The semiconductor device according to claim 6 or 7, wherein
said Schottky electrode contains at least one of Ni, Pt, Pd, and Au, and
said interface layer is formed in such a manner that at least one of Ni, Pt, Pd, and Au is soluble in said third group-III nitride.

9. The semiconductor device according to any one of claims 1 to 8, wherein
root-mean-square surface roughness of said contact layer is 0.5 nm or less.

10. The semiconductor device according to claim 9, wherein
a film thickness of said contact layer is 0.5 nm to 6 nm.

11. The semiconductor device according to any one of claims 1 to 10, wherein
said second group-III nitride is Inₓ₂Al_{y2}N (x2 + y2 = 1, 0.14 ≤ x2 ≤ 0.24).

12. The semiconductor device according to any one of claims 1 to 11, wherein
said first group-III nitride is Al_{y1}Ga_{z1}N (y1 + z1 = 1, z1 > 0).

13. The semiconductor device according to claim 12, wherein
said first group-III nitride is GaN.

14. The semiconductor device according to claim 12 or 13, further comprising a spacer layer formed of a fourth group-III nitride having a composition of Inₓ₄Al_{y4}Ga_{z4}N (x4 + y4 + z4 = 1, y4 > 0) and having a bandgap larger than that of said second group-III nitride, between said channel layer and said barrier layer.

15. The semiconductor device according to claim 14, wherein
said fourth group-III nitride is AlN.

16. The semiconductor device according to any one of claims 1 to 15, wherein
an ohmic electrode is connected to the same contact layer for said Schottky electrode.

17. A HEMT device serving as the semiconductor device according to claim 16, wherein
said Schottky electrode is a gate electrode, and said ohmic electrode is a source electrode and a drain electrode.

18. A method of manufacturing a semiconductor device comprising an epitaxial substrate formed by laminating a group of group-III nitride layers on a base substrate in such a manner that (0001) crystal surfaces of said group-III nitride layers are substantially parallel to a substrate surface, and a Schottky electrode, said method comprising:
a channel layer forming step of forming a channel layer with a first group-III nitride having a composition of Inₓ₁Al_{y1}Ga_{z1}N (x1 + y1 + z1 = 1, z1 > 0), on the base substrate;
a barrier layer forming step of forming a barrier layer with a second group-III nitride having a composition ofInₓ₂Al_{y2}N (x2 + y2 = 1, x2 > 0, y2 > 0), on said channel layer;
a contact layer forming step of forming a contact layer with a third group-III nitride having insularity so as to be adjacent to said barrier layer; and
a Schottky electrode forming step of forming the Schottky electrode so as to be connected to said contact layer.

19. The method of manufacturing the semiconductor device according to claim 18, wherein
a bandgap of said second group-III nitride is larger than a bandgap of said first group-III nitride.

20. The method of manufacturing the semiconductor device according to claim 18 or 19, wherein
a bandgap of said third group-III nitride is larger than the bandgap of said second group-III nitride.

21. The method of manufacturing the semiconductor device according to any one of claims 18 to 20, wherein
said third group-III nitride is AlN.

22. The method of manufacturing the semiconductor device according to any one of claims 18 to 21, further comprising
a heat treatment step of performing a heat treatment under a nitrogen gas atmosphere on the semiconductor device in which said Schottky electrode has been connected.

23. The method of manufacturing the semiconductor device according to claim 22, wherein
in said heat treatment step, an interface layer is formed between said Schottky electrode and said contact layer.

24. The method of manufacturing the semiconductor device according to claim 23, wherein
said interface layer contains a constituent element of said contact layer and a constituent element of said Schottky electrode.

25. The method of manufacturing the semiconductor device according to claim 23 or 24, wherein
in said Schottky electrode forming step, said Schottky electrode is formed so as to contain at least one of Ni, Pt, Pd, and Au, and
in said heat treatment step, said interface layer is formed in such a manner that at least one of Ni, Pt, Pd, and Au is soluble in said third group-III nitride.

26. The method of manufacturing the semiconductor device according to any one of claims 18 to 25, wherein
said second group-III nitride is Inₓ₂Al_{y2}N (x2 + y2 = 1, 0.14 ≤ x2 ≤ 0.24).

27. The method of manufacturing the semiconductor device according to any one of claims 18 to 26, wherein
said first group-III nitride is Al_{y1}Ga_{z1}N (y1 + z1 = 1, z1 > 0).

28. The method of manufacturing the semiconductor device according to claim 27, wherein
said first group-III nitride is GaN.

29. The method of manufacturing the semiconductor device according to claim 27 or 28, further comprising a spacer layer forming step of forming a spacer layer with a fourth group-III nitride having a composition of Inₓ₄Al_{y4}Ga_{z4}N (x4 + y4 + z4 = 1, y4 > 0) and having a bandgap larger than that of said second group-III nitride, between said channel layer and said barrier layer.

30. The method of manufacturing the semiconductor device according to claim 29, wherein
said fourth group-III nitride is AlN.

31. The method of manufacturing the semiconductor device according to any one of claims 18 to 30, further comprising an ohmic electrode forming step of forming an ohmic electrode so as to be connected to said contact layer having said Schottky electrode thereon.
